# EUROPEAN PATENT APPLICATION

(11) **EP 0 801 146 A1**
(43) Date of publication of application: **15.10.1997**
(21) Application number: 97830179.4
(22) Date of filing: 15.04.1997
(51) Int. Cl.: C23C 14/06, C23C 16/30, B05D 7/24

(54) **Method for deposition of mixed organic-inorganic film**

(30) Priority: 17.04.1996 IT RM960240
(71) Applicant: CE.TE.V. CENTRO TECNOLOGIE DEL VUOTO, I-61067 Carsoli (AQ) (IT)
(72) Inventor: Misiano, Carlo, 00161 Rome (IT); Simonetti, Enrico, 00146 Rome (IT)

(57) **Abstract**

Method for the thin film deposition for plastic substrates, in which the deposited film is realised with a mixed organic-inorganic structure, particularly to be realised in a vacuum deposition plant of thin films, through PE-CVD and sputtering techniques. By this method, in the case of a multilayer structure, modifying the process parameters, the deposition of desired layers with different refractive indexes are obtained. The advantage lies in obtaining a range of refractive indexes in a predeterminable way, and the film obtained, in respect of the preceeding solutions, presents characteristics of more adherence and elasticity. The invention lies in the field of plastic substrates coatings and it can be applied on ophthalmic products, on scientific instrumentation and optical consumer products.

## Description

The invention relates a method for the optical deposition, with mixed organic-inorganic structure, particularly allowable for coating of plastic substrates to *apply* with ophthalmic products, with scientific instruments with optical apparatus, of large use, for example photographic cameras, cameras, photographic lenses and other plastic and transparent elements as computers screens, and other optical elements for *cars, buildings, other consumer products.*

In the large area of the optical components in plastics, there was a problem not solved jet, relating to the optical coating duration, realised through inorganic thin films vacuum deposition, because of the difference between thermal expansion coefficient of the plastics in respect of deposited materials for the realisation of the optical coatings.

The PE-CVD techniques (Plasma Enhanced Chemical Vapour Deposition) permits to realise optical films enough hard, and even enough *elastic,* being this for its organic part able to follow said expansions without damages. Actually it is possible to realise by this technique, only films with acceptable optical characteristics with a low refractive index (1.45 to 1.65), while, for higher refractive indexes absorbing films are obtained, when, for the realisation of optical multilayer coatings, as for an antireflecting coating, it is necessary to dispose of at least two materials with refractive index significantly different.

The present invention relates a process in which mixing a film basically organic of low refractive index, with an inorganic material at high refractive index (for ex. ZR O_{2,} ZN S, TI O_{2,} CE O₂, NB₂ O₃, ecc.) a non-absorbing film of an index of refractive medium-high can be obtained, bat with characteristics of enough elasticity and adherence, such to easily tollerate the expansions of the plastic substrate.

In addition, said process permits, suitably dosing in the mixture the quantity of inorganic material, to obtain a range of refractive indexes in a predetermined way, and even, if necessary, to realise optical films with a refractive index varying along the thickness.

The method, for which a patent is requested, has going to be described in the following, just for an orientative and not limitative aim. It can be realised in an existing plant already described in the Italian patent application No. RM93A000216 of the same applicant.

The PE.CVD source is the kind which utilises a RF of 13.56Mhz for the plasma generation and the precursor utilised for the matrix semi-organic film deposition, with low refractive index, like SiOₓ C_{y}, is an organosylane e.g. (TEOS, TEOVS), etc.

The source necessary for the vaporisation of the inorganic material, with high refractive index could be magnetron sputtering, in non reactive or reactive environment (for oxide or nitride deposition).

It must preceed as follows:
- arrange substrates on a cylindrical rotating substrates holder;
- then, after the cycle of vacuuming is done, the sources are activated and said substrates passe alternatively in front of the PE-CVD and sputtering sources;
- the atmosphere composition and the supplied power are dosed (actions necessary for controlling the organicity percentage of the deposited film, modifying contemporary even the hardness and the abrasion resistance); then the deposition of the film up to the desired thickness is done;
- in the case of a multilayer structure, varying the process parameters, a further deposition of other layers desired with different refractive indexes are done.

Each final film, composed by successive very thin layers results to be an homogenous mixture of the two materials (semi-organic and inorganic).

The zones of the deposition plant, in which the two different kinds of depositions are effected, can be maintained, by known techniques, under different pressures and with different compositions of the gaseous atmosphere.

The power supplied to the sputtering source will be an RF in the case of a dielectric target, or a DC in the case of a conductive target, for a reactive deposition. Varying the power supplied to the target, the percentage of the high refractive index material, on the final film, could be controlled and then its final refractive index.

## Claims

1. Method, for the optical film deposition, to be applied on plastic substrates, characterised by the fact that said deposition can be realised by a mixed inorganic-organic structure, being said method applying to a, under vacuum deposition plant of thin films.

2. Method, for the optical film deposition, as per claim 1, characterised by the fact to employ the PE-CVD and sputtering techniques for realising films with mixed organic-inorganic structure.

3. Method as for claims 1 and 2, characterised by the fact that to obtain said mixed organic-inorganic structure, it must proceed as follows:
- arrange substrates on a cylindrical and rotating substrate holder;
- then, after the vacuuming cycle is done, the sources are activated and said substrates passe alternatively in front of the PE-CVD and sputtering sources;
- the atmosphere composition and the power supplied are dosed (actions necessary for controlling the organicity percentage of the deposited film), modifying contemporary even the hardness and the resistance to the (abrasion) then the deposition of the film up to the desired thickness;

4. Method, as for claims 1 to 3, characterised by the fact that in the case of a multilayer structure, modifying the process parameters, it is possible make a deposition of the other desired layers with different refractive indexes.

5. Method, as for claims 1 and 2, characterised by the fact that the zones, of the plant in which are effected the two kinds of deposition, can be maintained through known techniques, under different pressures and with different compositions of the gaseous atmosphere.

6. Method, of optical film deposition, as for the preceding claims, characterised by the fact that the power supplied to the sputtering source, can be either an RF or DC.

7. Method, for optical film deposition, as for claim 6, characterised by the fact that varying the power supplied to the sources, the percentage of the high refractive index material present in the final film and then its final refractive index, can be controlled, even varying it along its thickness.
